# EUROPEAN PATENT APPLICATION

(11) **EP 2 333 861 A1**
(43) Date of publication of application: **15.06.2011**
(21) Application number: 09817449.3
(22) Date of filing: 28.09.2009
(51) Int. Cl.: H01L 51/42

(54) **TANDEM SOLAR CELL**

(30) Priority: 30.09.2008 JP 2008253158
(71) Applicant: JX Nippon Oil & Energy Corporation, Chiyoda-ku Tokyo 100-8162 (JP)
(72) Inventor: HAYASHI, Shinya, Yokohama-shi Kanagawa 231-0815 (JP); UCHIDA, Souichi, Yokohama-shi Kanagawa 231-0815 (JP); NAKAMURA, Tsutomu, Yokohama-shi Kanagawa 231-0815 (JP)
(74) Representative: Piotrowicz, Pawel Jan Andrzej
(86) International application number: PCT/JP2009/004926
(87) International publication number: WO 2010/038406

(57) **Abstract**

The present invention provides a tandem solar cell constituted for the purpose of hole blocking or electron blocking so that holes are not injected from a front subcell or electrons are not injected from a rear subcell, into an intermediate layer arranged between these subcells. The tandem solar cell comprises a pair of electrodes, at least two or more subcells, and intermediate layers each arranged between two adjacent subcells, where at least one of the intermediate layers has a hole blocking layer or an electron blocking layer. In particular, holes or electrons can be blocked more completely by adjusting the thickness of the hole blocking layer or electron blocking layer to be equal to or greater than the maximum value of surface irregularity height of the subcell immediately before the hole or electron blocking layer so that the tandem solar cell can exhibit its performances sufficiently.

## Description

### Technical Field

The present invention relates to tandem solar cells. In particular, the present invention relates to a tandem solar cell comprising at least two subcells.

### Background Art

Recently, development of new energy that is economical and less in global environment load has been sought because various issues concerning energies or CO₂ have become serious. Under such circumstances, solar cells have been expected to be new clean energy sources since they are inexhaustible in supply of resources therefor and are not accompanied with CO₂ emission. Amongst, a silicon-based inorganic solar cell is relatively high in energy conversion efficiency and thus has already been put in practical use. However, due to its high production cost, it has not been widely used yet. Meanwhile, an organic thin film solar cell is still poor in conversion efficiency, but the research and development of such a solar cell have been progressed because the cell can be produced to have a large area in an easy and inexpensive manner.

Conventional organic thin film solar cells exhibited relatively high conversion efficiency as described in a report where a fullerene derivative, which is an electron transporting material, referred to as PCBM and poly(3-hexylthiophene), which is a hole transporting material, referred to as P3HT are mixed in a solution and formed into a film on a substrate by spin-casting so as to form a bulk heterojunction (see non-patent document 1 below) and in a report where a perylene derivative (PTCBI), which is an electron transporting material and phthalocyanine, which is a hole transporting material are co-deposited so as to form a bulk heterojunction (see non-patent document 2 below). However, the conversion efficiency of these solar cells is still lower than the conversion efficiency of the silicon-based inorganic solar cell. Therefore, a significant improvement in conversion efficiency is now an important issue for the practical use of the organic thin film solar cell.

Whilst, a tandem solar cell is configured by connecting electrically two or more subcells in series so that open-circuit voltage from each subcell is stored and thus can be expected to improve the open circuit voltage. The tandem solar cell is, therefore, deemed an effective means to improve the conversion efficiency. Further, an improvement in light use efficiency can also be expected by stacking subcells. However, the short circuit current is restricted by that of the smallest subcell, and thus optimization in selections of the type of subcell, order of stacking the subcells, and the film thickness on the subcells is required, taking account for the absorption range or efficiency of each subcell. Further, in order to connect subcells electrically, an intermediate layer is necessarily arranged between the subcells. Compounds used for the intermediate layer and the thickness thereof are also necessarily optimized to gain higher efficiency.

### Prior Art Documents

### Non-patent Documents

Non-Patent Document 1: "Science", pp 1474-1476, vol. 258, 1992, by N. S. Sariciftci, L. Smilowitz, A. J. Heeger, F. Wudl
Non-Patent Document 2: "Appl. Phys. Lett", pp 1062, vol. 58, 1991, by M. Hiramoto, H. Fujiwara, M. Yokoyama

### Disclosure of Invention

### Technical Problem

When a tandem solar cell is configured, it is necessary to connect two or more subcells electrically in series, and an intermediate layer is disposed between two adjacent subcells. This intermediate layer is a site where electrons injected from the front subcell are recombined with holes injected from the rear subcell. The intermediate layer is preferably transparent or semi-transparent or thinner as much as possible so that an incident light can reach at the rear subcell. If holes are injected from the front subcell or electrons are injected from the rear subcell, into the intermediate layer, the tandem solar cell can not exhibit its performances sufficiently.

### Solution to Problem

Holes or electrons must be completely blocked so that holes are not allowed to be injected from the front subcell or electrons are not allowed to be injected from the rear subcell, into the intermediate layer.
In particular, in the case where the electron transporting material and hole transporting material contained in the subcells form a bulk heterojunction, these materials are mixed on the surfaces of the subcells, making it difficult to block holes or electrons completely.
The present invention was accomplished as the result of the finding that complete hole or electron blocking was able to be achieved by observing the surface irregularity of a subcell immediately before formation of a hole blocking layer or an electron blocking layer and then forming a hole blocking layer or an electron blocking layer, having a thickness equal to or greater than the maximum value of surface irregularity height on the subcell.

That is, the present invention relates to a tandem solar cell comprising a pair of electrodes, at least two or more subcells, intermediate layers each arranged between two adjacent subcells, at least one of the intermediate layers having a hole blocking layer or an electron blocking layer.
The present invention also relates to the foregoing tandem solar cell, where the thickness of the hole blocking layer is greater than the maximum value of surface irregularity height of the subcell immediately before the hole blocking layer.
The present invention also relates to the foregoing tandem solar cell, where the thickness of the electron blocking layer is greater than the maximum value of surface irregularity height of the subcell immediately before the electron blocking layer.
The present invention also relates to the foregoing tandem solar cell, wherein it has at least one or more subcell having a bulk heterojunction formed with an electron transporting material and a hole transporting material.
The present invention also relates to the foregoing tandem solar cell, where the electron transporting material and hole transporting material existing in the xth subcell have a bulk heterojunction and the xth intermediate layer has a hole blocking layer or an electron blocking layer.
The present invention also relates to the foregoing tandem solar cell, where at least one of the subcells contains an electrically conductive polymer.
The present invention also relates to the foregoing tandem solar cell, where the xth subcell contains an electrically conductive polymer, and the xth intermediate layer has a hole blocking layer or an electron blocking layer.
The present invention also relates to the foregoing tandem solar cell, where the x is an integer of 1.
The present invention also relates to the foregoing tandem solar cell, where the hole blocking layer comprises an electron transporting material.
The present invention also relates to the foregoing tandem solar cell, where the electron blocking layer comprises a hole transporting material.

### Advantageous Effects of Invention

An intermediate layer arranged between adjacent subcells in a tandem solar cell is formed of a hole blocking layer or an electron blocking layer so that the thickness thereof is equal to or greater than the maximum value of the surface irregularity height of the subcell immediately before the hole or electron blocking layer. As the result, complete hole blocking or electron blocking can be achieved thereby producing an highly efficient tandem solar cell.

### Brief Description of Drawings

[Fig. 1] a schematic sectional view showing the structure of a tandem solar cell;
[Fig. 2] a photograph of a film surface observed through an atomic force microscope.

### Description of Embodiments

The present invention will be described in detail below.

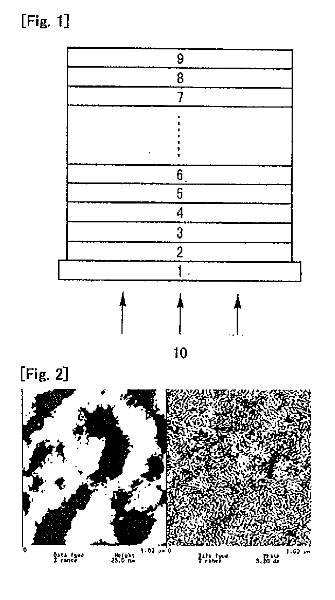

Fig. 1 is a sectional view showing an example of a tandem solar cell in accordance with the present invention. In this example, a tandem solar cell is configured by stacking subcells electrically in series via intermediate layers.

A substrate 1 is a transparent substrate. The material, thickness, size, and shape of the substrate can be properly selected depending on the purposes. For examples, the substrate may be selected from colorless or colored glasses, wire glasses, and glass blocks. Alternatively, the substrate may be a colored or colorless transparent resin. Specific examples of such a resin include polyesters such as polyethylene terephthalate, polyamides, polysulfones, polyethersulfones, polyether ketones, polyphenylene sulfides, polycarbonates, polyimides, polymethyl methacrylates, polystyrenes, cellulose triacetates, and polymethyl pentenes. The term "transparent" used herein denotes a transmissivity of 10 to 100 percent, preferably 50 percent or greater. The substrates used herein may be those having a smooth surface at ordinary temperature, which surface may be flat or curved or deformable with stress. On the side of the substrate 1 to which light is made incident may be provided a surface protection such as an ultraviolet shielding film.

Assuming that an incident light 10 enter from the substrate 1, no particular limitation is imposed on the cathode electrode 2 as long as it is transparent or translucent and the purposes of the present invention can be achieved. Examples of materials for forming the cathode electrode 2 include electrically conductive metal oxides such as SnO₂, ZnO, ITO (Indium doped Tin Oxide), FTO (Fluorine doped Tin Oxide), AZO (Aluminum doped Zinc Oxide) and IZO (Indium doped Zinc Oxide), and metal films of gold, silver, copper, or aluminum.

Each subcell has a photoactive layer. The photoactive layer contains a hole transporting material and an electron transporting material, forming together a bulk heterojunction or a planar heterojunction. The photoactive layer may be formed by a conventional method such as vacuum deposition, electron-beam vacuum deposition, sputtering or spin-coating. The greater thickness of the photoactive layer is better to capture light efficiently. The thickness of the photoactive layer varies on the hole transporting material and electron transporting material to be used but is preferably from 100 to 10000 Å.

Examples of the hole transporting material include electrically conductive polymers such as polythiophene, polypyrrole, polyanyline, polyfurane, polypyridine and polycarbazole; organic dye molecules such as phthalocyanine, porphyrin, and perylene, and derivatives or transition metal complexes thereof; charge transferring agents such as triphenylamine compounds and hydrazine compounds; and charge transferring complexes such as tetrathiafulvalene (TTF) but are but not limited thereto.

Examples of the electron transporting material include carbon materials such as fullerene (C₆₀, C₇₀), chemically-modified fullerene derivatives, and carbon nanotube, and perylene derivatives but are not limited thereto.

The intermediate layer is a site where the electrons injected from the subcell preceding the layer are recombined with the holes injected from the subcell following the layer, and efficient recombination is required. The intermediate layer is preferably transparent or translucent, or thinner as much as possible so that the incident light 10 can reach at the following subcell(s).
The intermediate layer preferably contains both or either one of the above-described hole transferring material and electron transferring material and may also contain a metal layer. The metal layer is preferably thinner as much as possible and translucent so that the incident light 10 can reach at the rear subcells. Further, the intermediate layer may contain electrically conductive metal oxides such as SnO₂, ZnO, ITO (Indium doped Tin Oxide), FTO (Fluorine doped Tin Oxide), AZO (Aluminum doped Zinc Oxide), IZO (Indium doped Zinc Oxide), MoOX but not limited thereto.

In the present invention, at least one of the intermediate layers arranged between two adjacent subcells has a hole blocking layer or an electron blocking layer.
The hole blocking layer contained in the intermediate layer is a layer for inhibiting injection of holes from the subcell to the intermediate layer while the electron blocking layer is a layer for inhibiting injection of electrons from the subcell to the intermediate layer. Therefore, preferably the above-described electron transporting material forms a hole blocking layer while the above-described hole transporting material forms an electron blocking layer but is not limited thereto.

The hole blocking layer and electron blocking layer may be formed by a conventional method such as vacuum deposition, electron beam vacuum deposition, sputtering or spin coating. In general, these layers are formed on a subcell by laminating them using any of the aforesaid conventional methods.

The hole blocking layer or electron blocking layer preferably has a film thickness that is smaller as much as possible so that light can be made incident efficiently into the following subcells but necessarily has a film thickness that is sufficient to exhibit a hole or electron blocking function.
The film thickness of the hole blocking layer or electron blocking layer is necessarily equal to or greater than the surface irregularity height (equal to or greater than the maximum value of irregularity height) of the subcell immediately before the hole blocking layer or electron blocking layer. Specifically, the film thickness of the hole blocking layer and electron blocking layer is greater than the maximum value of the surface irregularity height by 1 to 1000 Å, more preferably 10 to 500 Å, more preferably 50 to 300 Å.

The tandem solar cell of the present invention preferably has at least one or more subcell in which the electron transporting material and hole transporting material form a bulk heterojunction. Preferably, the electron transporting material and hole transporting material existing in the xth (preferably x=1) subcell have a bulk heterojunction, and the xth intermediate layer has a hole blocking layer or an electron blocking layer. That is, preferably the intermediate layer immediately following the subcell in which the electron transporting material and hole transporting material have a bulk heterojunction has a hole blocking layer or an electron blocking layer.

In the tandem solar cell of the present invention, at least one of the subcells preferably contains an electrically conductive polymer, and preferably the xth subcell (preferably x=1) contains an electrically conductive polymer while the xth intermediate layer has a hole blocking layer or an electron blocking layer. That is, the intermediate layer immediately following the subcell containing an electrically conductive polymer preferably contains a hole blocking layer or an electron blocking layer.

No particular limitation is imposed on the anode electrode 9 as long as the purposes of the present invention can be achieved. Examples of the anode electrode include metal electrodes such as gold, silver, and aluminum and carbon electrodes. The anode electrode 9 may be formed by vacuum deposition, electron beam vacuum deposition or sputtering or a conventional method where metal fine particles dispersed in a solvent is coated, and then the solvent is removed by evaporation. Upon formation of the metal electrode, layer of various organic and inorganic materials may be formed between the subcell and the metal electrode so as to bring the subcell into ohmic contact with the metal electrode. No particular limitation is imposed on such materials as long as they can achieve the purposes of the present invention. Examples include organics such as phenanthrorine and bathocuproin (BCP) and inorganics such as LiF and TiOx.

Various sealing treatments may be carried out in order to improve the durability of the solar cell of the present invention. No particular limitation is imposed on the method of sealing as long as it meets the purposes of the present invention. For example, the cell may be sealed using various materials with low gas permeability. The method using such materials with gas low permeability may be carried out using a material such as the above-mentioned substrate material as a gas barrier layer that is attached to the cell using an adhesive with low gas permeability thereby improving the durability of the cell.

### Examples

The present invention will be described in more details with reference to the following examples but is not limited thereto.

### (Example 1)

A substrate 1 was a glass substrate on which ITO with a surface resistance of 15 Ω/sq was formed into film by sputtering as a cathode electrode 2.
The substrate 1 having the cathode electrode 2 in the form of film was subjected to ultrasonic cleaning in neutral detergent for 10 minutes and then subjected to ultrasonic cleaning twice each in water, acetone, and ethanol for 3 minutes. Thereafter, the substrate was subjected to a UV ozone surface treatment for 3 minutes.
Next, Baytron P (manufactured by H. C. Stark) was spin-coated at 5000 rpm (30 s) over the cathode electrode 2 and dried at a temperature of 120°C for 10 minutes thereby forming a poly(ethylenedioxythiophene)/poly(styrene sulfonate), i.e., PEDOT/PSS layer, which is a hole transporting layer.
Next, in the following manner, a first subcell was formed on the ITO electrode/hole transporting layer.
Phenyl C₆₁-butyric acid methyl ester: PCBM (manufactured by ADS, Inc) and poly (3-hexylthiophene) with a molecular weight of 17500 (manufactured by Aldrich) were used as an electron transporting material and a hole transporting material, respectively and mixed at a weight ratio of 1:1 in o-dichlorobenzene so that the concentration of PCBM was 1.26 percent by weight. The mixed solution thus produced was spin-coated at 800 rpm (30 s) over the PEDOT/PSS layer thereby forming a photoactive layer. Thereafter, the substrate with the photoactive layer was dried under nitrogen over the night and then dried at a temperature of 110°C for 10 minutes thereby forming a first subcell.
The surface of the first subcell produced above was observed through an atomic force microscope (µm x 1 µm). A photography taken with the microscope is shown in Fig. 2. As the result, it was observed that the maximum surface irregularity height was on the order of 250 Å and both P3HT and PCBM existed on the surface.

### (Example 2)

In accordance with Example 1, a first subcell was formed, on which surface a first intermediate layer was formed in the following manner.
A layer of C₆₀, i.e., hole blocking layer was formed under a vacuum of about 10⁻⁵ torr, maintaining a deposition rate of 1 to 2 Å/s. The thickness of the layer was made 400 Å, which was thicker than the maximum irregularity height (250 Å) of the first subcell. Thereafter, a layer of 3,4,9,10-perylenetetracarboxylic bisbenzimidazole (PTCBI) with a thickness of 100 Å and a layer of Au with a thickness of 5 Å were deposited, maintaining deposition rates of 2 to 3 Å/s and about 1 Å/s, respectively.
Next, a second subcell was formed on the surface of the first intermediate layer in the following manner.
First of all, copper phthalocyanine (CuPc) was formed, maintaining a deposition rate of 1 to 2 Å/s so as to have a thickness of 200 Å thereby forming a hole transporting layer. Thereafter, C₆₀ was deposited, maintaining a deposition rate of 1 to 2 Å/s so as to have a thickness of 400 Å thereby forming an electron transporting layer.
Lastly, bathocuproin (BCP) was deposited on the surface of the second subcell , maintaining a deposition rate of 1 to 2 Å/s so as to have a thickness of 75 Å, and then Ag was deposited, maintaining a deposition rate of 3 to 4 Å/s so as to have a thickness of 600 Å and to form an anode electrode 9 thereby producing a tandem solar cell (see Fig. 1).
The resulting tandem solar cell was irradiated with a simulated sunlight of 100 mW/cm² to measure the current-voltage characteristics. The result is set forth in Table 1. The maximum efficiency was calculated from current-voltage characteristics.

### (Example 3)

The procedures of Example 2 were repeated except that the thickness of the hole blocking layer of the intermediate layer was made 300 Å that was thicker than the surface irregularity height (250 Å) of the first subcell thereby producing a tandem solar cell. The current-voltage characteristics of the cell was evaluated. The results are set forth in Table 1.

### (Example 4)

The procedures of Example 2 were repeated except that the thickness of the hole blocking layer of the intermediate layer was made 550 Å that was thicker than the surface irregularity height (250 Å) of the first subcell thereby producing a tandem solar cell. The current-voltage characteristics of the cell was evaluated. The results are set forth in Table 1.

### (Example 5)

In accordance with Example 1, a first subcell was formed, on which surface a first intermediate layer was formed in the following manner.
A layer of C₆₀, i.e., hole blocking layer was formed under a vacuum of about 10⁻⁵ torr, maintaining a deposition rate of 1 to 2 Å/s. The thickness was made 400 Å, which was thicker than the surface irregularity height (250 Å) of the first subcell. Thereafter, a layer of 3,4,9,10-perylenetetracarboxylic bisbenzimidazole (PTCBI) with a thickness of 100 Å and a layer of Au with a thickness of 5 Å were deposited, maintaining deposition rates of 2 to 3 Å/s and about 1 Å/s, respectively. Copper phthalocyanine (CuPc), i.e., electron blocking layer was then formed, maintaining a deposition rate of 1 to 2 Å/s. The thickness of the layer was made 300 Å that was thicker than the surface irregularity height (250 Å) of the first subcell.
Next, on the surface of the first intermediate layer were co-deposited copper phthalocyanine (CuPc) that is a hole transporting layer and C₆₀ that is an electron transporting layer, both having a thickness of 700 Å, maintaining a deposition rate of 1 to 2 Å/s so as to bring the hole transporting material and electron transporting material into bulk heterojunction thereby forming a second subcell.
Lastly, bathocuproin (BCP) was deposited on the surface of the second subcell, maintaining a deposition rate of 1 to 2 Å/s so as to have a thickness of 75 Å, and then Ag was deposited, maintaining a deposition rate of 3 to 4 Å/s so as to have a thickness of 600 Å and to form a 600 Å thickness anode electrode 9 thereby producing a tandem solar cell (see Fig. 1).
The resulting tandem solar cell was irradiated with a simulated sunlight of 100 mW/cm² to measure the current-voltage characteristics. The result is set forth in Table 2. The maximum efficiency was calculated from current-voltage characteristics.

### (Comparative Example 1)

The procedures of Example 2 were repeated except that the thickness of the hole blocking layer of the intermediate layer was made 100 Å that was thinner than the surface irregularity height (250 Å) of the first subcell thereby producing a tandem solar cell. The current-voltage characteristics of the cell was evaluated. The results are set forth in Table 1.

### (Comparative Example 2)

The procedures of Example 5 were repeated except that the thickness of the electron blocking layer of the intermediate layer was made 100 Å that was thinner than the surface irregularity height (250 Å) of the first subcell thereby producing a tandem solar cell. The current-voltage characteristics of the cell was evaluated. The results are set forth in Table 2.

**[Table 1]**

| | Hole blocking layer thickness (Å) | J_{SC} (mA/cm²) | V_{CC} (V) | FF (-) | η (%) |
|---|---|---|---|---|---|
| Example 2 | 400 | 0.93 | 0.83 | 0.57 | 0.43 |
| Example 3 | 300 | 1.01 | 0.83 | 0.54 | 0.45 |
| Example 4 | 550 | 0.82 | 0.84 | 0.59 | 0.41 |
| Comparative Example 1 | 100 | 1.28 | 0.58 | 0.38 | 0.29 |

**[Table 2]**

| | Electron blocking layer thickness (Å) | J_{SC} (mA/cm²) | V_{CC} (V) | FF (-) | η (%) |
|---|---|---|---|---|---|
| Example 2 | 300 | 1.30 | 0.86 | 0.61 | 0.68 |
| Comparative Example 1 | 100 | 1.39 | 0.35 | 0.32 | 0.16 |

When the thickness of the hole blocking layer (C₆₀ layer) was 100 Å that is thinner than the surface irregularity height of the first subcell, it was confirmed that only the second subcell worked, meaning that holes were injected from the first subcell to the intermediate layer. Whereas, when the hole blocking layers (C₆₀ layers) were used, whose thicknesses are 300, 400, and 500 Å, that are thicker than the surface irregularity height of the first subcell, holes were blocked from injecting into the intermediate layer from the first subcell and the assemblies were worked as tandem devices. An improvement in efficiency by 5 percent or more can be expected by optimizing the materials to be used or structure of subcells.

When the thickness of the electron blocking layer (copper phthalocyanine layer) was 100 A that was thinner than the surface irregularity height of the first subcell, it was confirmed that only the first subcell worked, meaning that electrons were injected from the second subcell to the intermediate layer. Whereas, when the electron blocking layer (copper phthalocyanine layer) was used, whose thicknesses was 300 Å, that was thicker than the surface irregularity height on the first subcell, electrons were blocked from injecting into the intermediate layer from the second subcell and the assemblies were worked as tandem devices. An improvement in efficiency by 5 percent or more can be expected by optimizing the materials to be used or structure of subcells.

### Applicability in the Industry

The present invention provides a tandem solar cell that can achieve hole blocking or electron blocking completely.

### Description of Numerals

- 1: substrate
- 2: cathode electrode
- 3: hole transporting layer
- 4: first subcell
- 5: first intermediate layer
- 6: second subcell
- 7: nth-1 intermediate layer
- 8: nth subcell
- 9: anode electrode
- 10: incident light

## Claims

1. A tandem solar cell comprising a pair of electrodes, at least two or more subcells, intermediate layers each arranged between two adjacent subcells, at least one of the intermediate layers having a hole blocking layer or an electron blocking layer.

2. The tandem solar cell according to claim 1, where the thickness of the hole blocking layer is equal to or greater than the maximum value of surface irregularity height of the subcell immediately before the hole blocking layer.

3. The tandem solar cell according to claim 1, where the thickness of the electron blocking layer is greater than the maximum value of surface irregularity height of the subcell immediately before the electron blocking layer.

4. The tandem solar cell according to any one of claims 1 to 3, wherein it has at least one or more subcell having a bulk heterojunction formed with an electron transporting material and a hole transporting material.

5. The tandem solar cell according to any one of claims 1 to 4, where the electron transporting material and hole transporting material existing in the xth subcell have a bulk heterojunction and the xth intermediate layer has a hole blocking layer or an electron blocking layer.

6. The tandem solar cell according to any one of claims 1 to 5, where at least one of the subcells contains an electrically conductive polymer.

7. The tandem solar cell according to any one of claims 1 to 6, where the xth subcell contains an electrically conductive polymer, and the xth intermediate layer has a hole blocking layer or an electron blocking layer.

8. The tandem solar cell according to claim 5 or 7, where the x is an integer of 1.

9. The tandem solar cell according to any one of claims 1 to 8, where the hole blocking layer comprises an electron transporting material.

10. The tandem solar cell according to any one of claims 1 to 9, where the electron blocking layer comprises a hole transporting material.
